# EUROPÄISCHE PATENTSCHRIFT

(11) **EP 2 606 494 B1**
(45) Veröffentlichungstag und Bekanntmachung des Hinweises auf die Patenterteilung: **01.05.2019**
(21) Anmeldenummer: 11766911.9
(22) Anmeldetag: 19.09.2011
(51) Int. Cl.: F28D 15/02, F28D 15/06, B63H 21/38, H02K 55/04, F25D 19/00

(54) **VORRICHTUNG UND VERFAHREN ZUR KÜHLUNG EINER SUPRALEITENDEN MASCHINE**
DEVICE AND METHOD FOR COOLING A SUPERCONDUCTING MACHINE
SYSTÈME ET PROCÉDÉ DE REFROIDISSEMENT D'UNE MACHINE SUPRACONDUCTRICE

(30) Priorität: 22.09.2010 DE 102010041194
(43) Veröffentlichungstag der Anmeldung: 26.06.2013
(73) Patentinhaber: Siemens Aktiengesellschaft, 80333 München (DE)
(72) Erfinder: FRANK, Michael, 91080 Uttenreuth (DE); VAN HASSELT, Peter, 91058 Erlangen (DE)
(86) Internationale Anmeldenummer: PCT/EP2011/066167
(87) Internationale Veröffentlichungsnummer: WO 2012/038357

(56) Entgegenhaltungen:
- DE-A1- 10 158 758
- DE-A1- 10 321 463
- DE-B3-102004 001 805
- DE-B3-102005 002 361
- DE-B3-102006 035 094
- US-A- 4 961 463
- US-A- 5 587 880

## Beschreibung

Die vorliegende Erfindung bezieht sich auf ein Verfahren zur Kühlung einer supraleitenden Maschine, bei welchen wenigstens zwei Kondensorräume jeweils mit einem Kaltkopf in thermischen Kontakt stehen und bei welchen die wenigstens zwei Kondensorräume jeweils eine Verbindungsleitung aufweisen, über welche die wenigstens zwei Kondensorräume fluidisch mit einem Verdampferraum in Verbindung stehen.

Supraleitende Maschinen umfassen in der Regel supraleitende Spulen, welche zumindest während des Betriebs der Maschine zuverlässig gekühlt werden müssen. Seit 1987 kennt man metalloxidische Supraleitermaterialien mit Sprungtemperaturen T_{c} von über 77 K. Diese Materialien werden auch als Hoch(High)-T_{c}-Supraleitermaterialien oder HTS-Materialien bezeichnet und ermöglichen prinzipiell eine Kühltechnik mit flüssigem Stickstoff (LN₂). Maschinen, welche Spulen mit HTS-Material umfassen, können somit z.B. mit flüssigem Stickstoff (LN₂) oder mit flüssigem Neon (LNe) gekühlt bzw. betrieben werden.

Zur Kühlung von Wicklungen mit HTS-Material kommen bevorzugt Kälteanlagen in Form von sogenannten Kryokühlern mit geschlossenem He-Druckgaskreislauf zum Einsatz. Solche Kryokühler sind insbesondere vom Typ Gifford-McMahon oder Stirling oder sind als sogenannte Pulsröhrenkühler ausgebildet. Sie haben den Vorteil, dass ihre Kälteleistung quasi auf Knopfdruck zur Verfügung steht und die Handhabung von tiefkalten Flüssigkeiten vermieden wird. Bei Verwendung solcher Kälteanlagen wird die supraleitende Wicklung z.B. durch Wärmeleitung zu einem Kaltkopf eines Refrigerators indirekt gekühlt (vgl. z.B. "Proc. 16th Int. Cryog. Engng. Conf. (ICEC 16)", Kitakyushu, JP, 20.-24.05.1996, Verlag Elsevier Science, 1997, Seiten 1109 bis 1129).

Eine Kühltechnik, wie z.B. in der DE 103 21 463 A1 beschrieben, ist für die Kühlung von Rotoren elektrischer Maschinen einsetzbar. Der Rotor enthält eine rotierende Wicklung aus HTS-Leitern, die sich in einem wärmeleitend ausgebildeten Wicklungsträger befinden. Dieser Wicklungsträger ist mit einem zentralen, sich in Achsrichtung erstreckenden, zylindrischen Hohlraum ausgestattet, an den sich seitlich aus dem Wicklungsträger herausführende rohrförmige Leitungsteile anschließen. Diese Leitungsteile führen in einen geodätisch höher liegenden Kondensorraum einer Kälteeinheit und bilden zusammen mit diesem Kondensorraum und dem zentralen Rotorhohlraum ein geschlossenes Ein-Rohr-Leitungssystem. In diesem Leitungssystem befindet sich ein Kältemittel bzw. Kühlfluid, das unter Ausnutzung eines sogenannten Thermosiphon-Effektes zirkuliert. Hierbei wird in dem Kondensorraum kondensiertes Kühlfluid über die rohrförmigen Leitungsteile in den zentralen Hohlraum geleitet, wo es wegen der thermischen Ankopplung an den Wicklungsträger und damit an die HTS-Wicklung Wärme aufnimmt und verdampft. Das verdampfte Kühlfluid gelangt dann zurück über dieselben Leitungsteile in den Kondensorraum, wo es zurückkondensiert wird. Die hierfür erforderliche Kälteleistung wird von einer Kältemaschine erbracht, deren Kaltkopf an den Kondensorraum thermisch angekoppelt ist.

Die Druckschrift DE 10 58 758 A1 offenbart eine Vorrichtung zur Kühlung einer supraleitenden Maschine mit zwei Kaltköpfen, die jeweils über eine Verbindungsleitung mit einem Kryostaten verbunden sind, um die elektrische Maschine zu kühlen.

Der Rückstrom des Kältemittels wird dabei getrieben durch einen leichten Überdruck in den als Verdampferteil wirkenden zentralen Hohlraum hin zu dem als Kondensator wirkenden Teilen der Kältemaschine. Dieser, durch das Entstehen von Gas im Verdampferteil und das Verflüssigen im Kondensorraum erzeugte Differenzdruck, führt also zu dem gewünschten Kältemittelrückstrom. Entsprechende Kältemittelströmungen sind von sogenannten "Heat-Pipes" prinzipiell her bekannt.

Bei der bekannten Maschine mit Thermosiphon-Kühlung mittels einer entsprechenden Kälteeinheit erfolgt also der Transport des flüssigen Kältemittels allein unter Ausnutzung der Schwerkraft, so dass keine weiteren Pumpsysteme erforderlich sind. Dies erfordert eine Kälteeinheit bzw. einen Kondensorraum, welcher zwingend geodätisch höher angeordnet sein muss als die Maschine bzw. der Wicklungsträger. Damit verbundene Nachteile treten insbesondere bei räumlichen Beschränkungen des Maschinen- und Kälteeinheitsaufbaus auf. So kann z.B. bei einer Maschine mit senkrecht angeordneter Maschinenachse ein mit der Maschine angetriebenes Objekt, z.B. ein Motor, oberhalb der Maschine angeordnet sein. Die Maschine ist derart in ihrer Umgebung eingebaut, dass in der Ebene der Maschine kein freier Raum vorhanden ist. Die geodätisch höhere Position ist durch das angetriebene Objekt besetzt, und eine Anordnung der Kälteeinheit geodätisch höher ist in dieser Situation nicht möglich. Auch in komplexen Anwendungen, wie z.B. bei Triebwagen von Eisenbahnen, kann z.B. aus Vorschriften auf Grund von Oberleitungs- und/oder Tunnelhöhen die Bauhöhe des Triebwagens beschränkt sein. Bei gegebenen Maschinengrößen, welche in der Größenordnung der Höhenvorschrift liegen, kann selbst bei waagerechter Anordnung der Maschinenachse eine Anordnung der Kälteeinheit geodätisch höher als die Maschine nicht möglich sein.

Ein weiterer Fall, bei welchem Probleme bei einem rein schwerkraftgetriebenen Kühlmittelfluss auftreten, ist auf Schiffen oder Off-shore-Einrichtungen gegeben. Will man eine zuvor beschriebene Maschineneinrichtung auf Schiffen oder Off-shore-Einrichtungen einsetzen, so muss vielfach mit statischen Schieflagen, einem sogenannten "Trim", von z.B. bis zu ±5° und/oder mit dynamischen Schieflagen von z.B. bis zu ±7,5° in Längsrichtung gerechnet werden. Um eine Zulassung einer Klassifizierungsgesellschaft für einen Schiffseinsatz zu erhalten, muss folglich das Kühlsystem einer solchen Maschineneinrichtung an Bord eines Seefahrzeugs auch unter diesen Bedingungen eine sichere Kühlung gewährleisten. Will man die genannten Schieflagen der Maschine zulassen, so besteht dann die Gefahr, dass ein Bereich der rohrförmigen Leitungsteile zwischen dem zentralen Rotorhohlraum und der Kälteeinheit geodätisch tiefer zu liegen kommt als der zentrale Rotorhohlraum. Die Folge davon ist, dass das Kältemittel unter Einfluss der Schwerkraft den zu kühlenden Rotorhohlraum nicht erreichen kann. Eine Kühlung der Maschine und somit deren Betrieb wäre damit nicht mehr sichergestellt.

Um eine zuverlässige Kühlung auch bei Schieflagen der Maschine zu gewährleisten, ist es möglich die Maschine gegenüber der Horizontalen so geneigt anzuordnen, dass auch bei größter anzunehmender Trimlage oder Oszillationsamplitude in dem Thermosiphon-Leitungssystem immer noch ein Gefälle in Richtung auf den Rotorhohlraum vorhanden ist. Eine entsprechend geneigte Anordnung ist gerade im Schiffsbau insbesondere bei größerer Maschinenlänge aus Gründen eines dann erforderlichen großen Platzbedarfs unerwünscht. Alternativ kann statt eines Ein-Rohr-Leitungssystems für eine Kältemittelzirkulation zwischen einem Kondensorraum und dem Verdampferraum, bei dem das flüssige und das gasförmige Kältemittel durch gleiche Rohrteile vom und zum Kondensorraum strömen, ein Zwei-Rohr-Leitungssysteme verwendet werden. Dabei wird der Thermosiphon-Effekt genutzt, wie er z.B. in der WO 00/13296 A beschrieben ist. Es muss jedoch im Bereich der Hohlwelle des Rotors ein zusätzliches Rohr für das gasförmige Kältemittel vorgesehen werden. Der Kondensorraum muss geodätisch gegenüber dem Verdampferraum hoch genug angeordnet sein, um über die Schwerkraft eine zuverlässige Strömung des Kühlfluids aus dem Kondensorraum in den Verdampferraum sicherzustellen. Dies erfordert Bauraum, welcher z.B. in Schiffen nur beschränkt zur Verfügung steht.

Eine weitere Alternative stellt die Verwendung einer mechanischen Pumpe und/oder von mechanischen Ventilen dar. Das Kältemittel kann durch eine Pumpanlage zwangsumgewälzt werden. Hierfür ist jedoch ein erheblicher apparativer Aufwand erforderlich, insbesondere wenn das Kältemittel z.B. eine Temperatur von 25 bis 30 K aufweist. Derartige Umwälzanlagen bedingen erhebliche Verluste und können die Lebensdaueranforderungen des Schiffsbaus mit seinen langen Wartungsintervallen kaum erfüllen.

Aufgabe der vorliegenden Erfindung ist es deshalb, ein Verfahren zur Kühlung einer supraleitenden Maschine anzugeben, welches eine zuverlässige Kühlung auch bei Schieflagen von Maschinen ermöglicht. Dabei soll auf mechanisch bewegliche Teile, wie z.B. mechanische Pumpen und Ventile verzichtet werden, da diese bei kryogenen Temperaturen aufwendig, kostenintensiv und störanfällig sind. Weitere Aufgabe der vorliegenden Erfindung ist es, ein Verfahren anzugeben, bei welchem ein Kühlfluid auch entgegen der Richtung bzw. Wirkung der Schwerkraft ohne mechanisch bewegte Teile wie z.B. mechanische Pumpen und Ventile bewegt werden kann.

Die angegebene Aufgabe wird mit den Merkmalen des Anspruchs 1 sowie mit den Merkmalen der Ansprüche 2, 5 und 6 gelöst.

Vorteilhafte Ausgestaltungen des Verfahrens zur Kühlung einer supraleitenden Maschine gehen aus den jeweils zugeordneten abhängigen Ansprüchen hervor.

Eine Vorrichtung zur Durchführung eines erfindungsgemäßen Verfahrens zur Kühlung einer supraleitenden Maschine weist wenigstens zwei Kondensorräume auf, welche jeweils mit einem Kaltkopf in thermischen Kontakt stehen. Dabei weisen die wenigstens zwei Kondensorräume jeweils eine Verbindungsleitung auf, über welche die wenigstens zwei Kondensorräume fluidisch mit einem Verdampferraum in Verbindung stehen. Die wenigstens zwei Kondensorräume sind derart ausgebildet, dass ein Kühlfluid in flüssiger Form auch gegen die Schwerkraft bewegbar ist, von wenigstens einem Kondensorraum in den Verdampferraum durch einen Druckunterschied zwischen einem ersten Druck im ersten Kondensorraum und einem zweiten Druck im zweiten Kondensorraum. Die Drücke sind jeweils durch die Temperatur in den Kondensorräumen bestimmt (Siedelinie des Kühlmittels).

Durch die Verwendung von zwei Kondensorräumen, mit jeweils einer Verbindungsleitung zum Verdampferraum, können die Temperaturen in den Kondensorräumen über die jeweils mit den Kondensorräumen thermisch gekoppelten Kaltköpfe unterschiedlich eingestellt werden. Dies ermöglicht den Aufbau eines Druckunterschieds zwischen den Kondensorräumen bzw. ihren Innenraumvolumen, welche mit flüssigem und/oder gasförmigem Kühlfluid gefüllt sind. In einem Kondensorraum, in welchem die Temperatur erhöht wird, verdampft Flüssigkeit und/oder dehnt sich das gasförmige Kühlfluid aus und der Druck erhöht sich. In einem Kondensorraum, in welchem die Temperatur erniedrigt bzw. verringert wird, verringert sich der Druck, da gasförmiges Kühlmittel kondensiert wird. Durch unterschiedliche Änderung der Temperatur in den Kondensorräumen bzw. über die Kaltköpfe, wird ein Druckunterschied zwischen den Kondensorräumen aufgebaut.

Der Druckunterschied bewirkt eine Bewegung von flüssigem Kühlfluid aus wenigstens einer Verbindungsleitung in den Verdampferraum. Dabei wird durch einen größeren Druck in einem Kondensorraum im Vergleich zum Verdampferraum, welcher durch einen größeren Druck in einem Kondensorraum im Vergleich zu einem anderen Kondensorraum entstehen kann, Kühlfluid in dem Verbindungsrohr des einen Kondensorraums in den Verdampferraum auch gegen die Schwerkraft bewegt, wenn der Druckunterschied groß genug ist. Dabei sind keinerlei beweglichen Teile wie Ventile oder mechanische Pumpen notwendig.

Es können auch wenigstens drei Kondensorräume mit jeweils einem Kaltkopf verwendet werden, wobei insbesondere in den wenigstens drei Kondensorräumen über den jeweils zugeordneten Kaltkopf unabhängig voneinander Temperatur geregelt oder gesteuert einstellbar ist. Vorteilhaft wird dann in zwei Kondensorräumen gleichzeitig die Temperatur erniedrigt und in einem Kondensorraum die Temperatur erhöht. Dabei kann zeitlich folgend zwischen den Kondensorräumen, in welchen die Temperatur erhöht und erniedrigt wird, getauscht werden, wobei aber immer in einem die Temperatur erhöht und in den anderen erniedrigt wird. So wird bewirkt, dass immer aus einem Verbindungsrohr flüssiges Kühlfluid strömt und eine zuverlässige Kühlung sicher gestellt ist. In den zwei Kondensorräumen, in welchen die Temperatur erniedrigt wird, kann während aus der Verbindungsleitung des dritten Kondensorraums flüssiges Kühlfluid in den Verdampferraum strömt, gasförmiges Kühlfluid verflüssigt werden, welches aus dem Verdampferraum in die zwei ersteren Kondensorräume strömt.

Über die Kondensorräume, die Verbindungen und den Verdampferraum kann ein geschlossener, insbesondere ein abgeschlossener Kühlkreislauf gebildet sein. Es geht kein Kühlfluid verloren und eine Wartung des Kühlmittelkreislaufs bzw. ein Auffüllen von Kühlfluid ist nicht notwendig, insbesondere wenn ein geeignet dimensionierter Ausgleichsbehälter vorgesehen ist.

Die Vorrichtung kann mit einem Kühlfluid befüllt sein, welches eine homogene Flüssigkeit, insbesondere flüssigen Stickstoff oder flüssiges Neon umfasst bzw. daraus besteht, oder welches eine Mischung aus Kühlflüssigkeiten mit unterschiedlichen Kondensationstemperaturen umfasst. Die Verdampfungstemperatur des Kühlfluids bestimmt die Temperatur, auf welche die supraleitende Wicklung bzw. Maschine gekühlt werden kann, d.h. welche supraleitenden Materialien eingesetzt werden können. Die Kondensationstemperatur des Kühlfluids bestimmt die Temperatur, auf welche die Kühlköpfe den Kondensorraum abkühlen müssen, um das verdampfte, gasförmige Kühlfluid wieder zu verflüssigen. Über Mischungen oder Zusätze zu den Kühlfluiden können auch Temperaturen eingestellt werden, bei welchen das Kühlfluid verdampft bzw. sich verflüssigt, welche zwischen Temperaturen liegen, bei welchen reine Stoffe wie z.B. reiner Stickstoff oder reines Helium verdampfen bzw. sich verflüssigen.

Die supraleitende Maschine kann ein Motor oder ein Generator sein, insbesondere mit einem Rotor mit wenigstens einer supraleitenden Wicklung, wobei der Rotor um eine Achse rotierbar angeordnet ist. Die supraleitende Wicklung kann aus HTS-Material bestehen oder dieses umfassen. Dies erlaubt die Verwendung von Stickstoff als Kühlfluid. Die Maschine kann z.B. in Schiffen eingesetzt werden.

Die Kondensorräume und die jeweils zugeordneten Kaltköpfe können feststehend außerhalb des Rotors angeordnet sein und der Verdampferraum kann innerhalb des Rotors, insbesondere als zylindrischer Hohlraum entlang der Rotationsachse des Rotors rotierbar angeordnet sein. Die Verbindungsrohre können nach dem Thermosiphonprinzip in den Verdampferraum ragen und ebenfalls feststehend sein. Dadurch werden günstige Eigenschaften der Maschine erreicht.

Ein erfindungsgemäßes Verfahren zur Kühlung einer supraleitenden Maschine, insbesondere unter Verwendung des Thermosiphoneffekts, umfasst die Schritte:
A) dass in einem ersten Kondensorraum, welcher mit einem ersten Kaltkopf thermisch in Verbindung steht, eine Temperatur erhöht wird, wobei der Druck im Kondensorraum erhöht wird, und flüssiges Kühlfluid in einem ersten Verbindungsrohr zwischen dem ersten Kondensorraum und einem Verdampferraum durch die Temperaturerhöhung und/oder Gasausdehnung in den Verdampferraum bewegt wird,
   und
B) dass gleichzeitig in wenigstens einem zweiten Kondensorraum, welcher mit einem zweiten Kaltkopf thermisch in Verbindung steht, eine Temperatur erniedrigt wird, insbesondere eine niedrigere Temperatur als im ersten Kondensorraum, wodurch gasförmiges Kühlfluid insbesondere über ein zweites Verbindungsrohr zwischen dem Verdampferraum und dem zweiten Kondensorraum durch die Temperaturerhöhung im ersten Kondensorraum und/oder durch die Temperaturerniedrigung im zweiten Kondensorraum aus dem Verdampferraum in den zweiten Kondensorraum bewegt wird.
   Ein alternatives erfindungsgemäßes Verfahren zur Kühlung einer supraleitenden Maschine, insbesondere unter Verwendung des Thermosiphoneffekts, umfasst die Schritte,
C) dass in einem ersten Kondensorraum, welcher mit einem ersten Kaltkopf thermisch in Verbindung steht und welcher über ein erstes Verbindungsrohr mit einem Verdampferraum fluidisch in Verbindung steht, eine Temperatur konstant gehalten wird,
   und
D) dass gleichzeitig in wenigstens einem zweiten Kondensorraum, welcher mit einem zweiten Kaltkopf thermisch in Verbindung steht, eine Temperatur erniedrigt wird, wodurch gasförmiges Kühlfluid über ein zweites Verbindungsrohr zwischen dem Verdampferraum und dem zweiten Kondensorraum durch die Temperaturerniedrigung im zweiten Kondensorraum aus dem Verdampferraum in den zweiten Kondensorraum bewegt wird,
   und
E) wodurch flüssiges Kühlfluid in dem ersten Verbindungsrohr zwischen dem ersten Kondensorraum und dem Verdampferraum in den Verdampferraum bewegt wird, durch die Temperaturerniedrigung im wenigstens zweiten Kondensorraum.

Dabei wird der Druckunterschied durch die Temperaturerhöhung im ersten Kondensorraum aufgebaut bzw. verstärkt, wodurch durch den dadurch im ersten Kondensorraum bestehenden Überdruck, auch im Vergleich zum Druck im Verdampferraum, flüssiges Kühlfluid in den Verdampferraum gedrückt wird. Eine Temperaturerhöhung ist einfach und schnell zu realisieren, wodurch hohe Druckunterschiede erzeugt werden können und das flüssige Kühlfluid über große Höhenunterschiede im Bereich von Zentimetern bis hin zu Metern gegen die Schwerkraft in der Verbindungsleitung bewegt werden kann.

Dabei wird der Druckunterschied durch die Temperaturerniedrigung im wenigstens zweiten Kondensorraum aufgebaut bzw. verstärkt, wodurch durch den dadurch im ersten Kondensorraum bestehenden Überdruck, auch im Vergleich zum Druck im Verdampferraum, flüssiges Kühlfluid in den Verdampferraum gedrückt wird. Bei der Temperaturerniedrigung kann gleichzeitig gasförmiges Kühlfluid im wenigstens zweiten Kondensorraum verflüssigt werden, welches zu einem späteren Zeitpunkt in den Verdampferraum bewegt werden kann.

Gleichzeitig kann wenigstens in einem dritten Kondensorraum, welcher mit einem dritten Kaltkopf thermisch in Verbindung steht, eine Temperatur konstant gehalten werden oder erniedrigt werden. So kann z.B. bei den Schritten C) bis E) ein höherer Unterdruck im ersten Kondensorraum erzeugt werden und in kurzer Zeit mehr flüssiges Kühlfluid in den Verdampferraum bewegt werden. Bei den Schritten A) und B) kann der Effekt des Aufbaus eines Druckunterschieds zwischen ersten und zweiten Kondensorraum durch einen dritten Kondensorraum unterstützt werden und ebenfalls in kurzer Zeit mehr flüssiges Kühlfluid in den Verdampferraum bewegt werden.

Zeitlich direkt oder indirekt folgend auf die Schritte A) und B) oder C) bis E) in dem wenigstens einem Kondensorraum, in welchem die Temperatur zur Zeit der Schritte A) und B) oder C) bis E) erhöht wurde oder konstant gehalten wurde, kann die Temperatur verringert oder konstant gehalten werden. In dem wenigstens einen zweiten, insbesondere dem zweiten und dritten Kondensorraum, in welchen die Temperatur zur Zeit der Schritte A) und B) oder C) bis E) konstant gehalten wurde oder verringert wurde, kann die Temperatur erhöht werden oder konstant gehalten werden.

Ein weiteres alternatives erfindungsgemäßes Verfahren zur Kühlung einer supraleitenden Maschine, insbesondere unter Verwendung des Thermosiphoneffekts, umfasst die Schritte, dass in einem ersten Kondensorraum, welcher mit einem ersten Kaltkopf thermisch in Verbindung steht, und dass gleichzeitig in wenigstens einem zweiten Kondensorraum, welcher mit einem zweiten Kaltkopf thermisch in Verbindung steht, eine Temperatur erhöht wird, wobei die Temperatur und/oder Temperaturerhöhung im ersten Kondensorraum größer ist als im zweiten Kondensorraum, wodurch im ersten Kondensorraum mehr Kühlfluid verdampft wird als im zweiten Kondensorraum und/oder sich Gas mehr ausdehnt und/oder ein Druckunterschied zwischen dem Druck im ersten und zweiten Kondensorraum entsteht oder erhöht wird, wodurch flüssiges Kühlfluid k in einem ersten Verbindungsrohr zwischen dem ersten Kondensorraum und einem Verdampferraum bewegt wird, und gasförmiges Kühlfluid k' insbesondere über ein zweites Verbindungsrohr von dem Verdampferraum in den zweiten Kondensorraum bewegt wird.

Alternativ können in einem erfindungsgemäßen Verfahren zur Kühlung einer supraleitenden Maschine, insbesondere unter Verwendung des Thermosiphoneffekts, die Schritte umfasst sein, dass in einem ersten Kondensorraum, welcher mit einem ersten Kaltkopf thermisch in Verbindung steht, und dass gleichzeitig in wenigstens einem zweiten Kondensorraum, welcher mit einem zweiten Kaltkopf thermisch in Verbindung steht, eine Temperatur verringert wird, wobei die Temperatur im ersten Kondensorraum kleiner ist als im zweiten Kondensorraum und/oder die Temperaturverringerung im ersten Kondensorraum größer ist als im zweiten Kondensorraum, wodurch im ersten Kondensorraum mehr Kühlfluid kondensiert wird als im zweiten Kondensorraum und/oder Gas mehr komprimiert wird und/oder ein Druckunterschied zwischen dem Druck im ersten und zweiten Kondensorraum entsteht oder erhöht wird, wodurch flüssiges Kühlfluid k in einem zweiten Verbindungsrohr zwischen dem zweiten Kondensorraum und einem Verdampferraum bewegt wird, und gasförmiges Kühlfluid k' insbesondere über ein erstes Verbindungsrohr von dem Verdampferraum in den ersten Kondensorraum bewegt wird.

Bei den beiden zuletzt genannten Verfahren kann gleichzeitig wenigstens in einem dritten Kondensorraum, welcher mit einem dritten Kaltkopf thermisch in Verbindung steht, eine Temperatur erhöht, gleichgehalten oder verringert werden.

Es kann zeitlich direkt oder indirekt folgend in Kondensorräumen, in welchen die Temperatur erhöht wurde, die Temperatur verringert werden, und/oder zeitlich direkt oder indirekt folgend in Kondensorräumen, in welchen die Temperatur verringert wurde, die Temperatur erhöht werden. Die zuvor beschriebenen Vorteile für Verfahren mit wenigstens drei Kondensorräumen, bei welchen deren Rollen zeitlich durchgetauscht werden, gelten hierbei ebenfalls.

Das Verfahren kann so als ein kontinuierlicher oder gepulster Prozess des Pumpens von flüssigem Kühlfluid in den Verdampferraum durchgeführt werden.

Eine Temperaturerniedrigung kann durch Kühlen mit Hilfe wenigstens eines Kaltkopfes erfolgen. Eine Temperaturerhöhung kann mit Hilfe wenigstens eines Kaltkopfes und/oder durch Heizen mit Hilfe einer Heizeinrichtung erfolgen.

Eine Bewegung von Kühlfluid kann ausschließlich geregelt oder gesteuert über Druck- und/oder Temperaturunterschiede in den Kondensorräumen und dem Verdampferraum erfolgen, insbesondere bei Druckausgleich durch Kühlfluidbewegung und/oder insbesondere gegen die Schwerkraft. Ventile oder mechanische Pumpen müssen nicht mehr eingesetzt werden, um flüssiges Kühlfluid in einer Verbindungsleitung auch gegen die Schwerkraft in den Verdampferraum zu bewegen. Probleme an mechanischen Teilen bei Kryotemperaturen werden so vermieden und Wartungsaufwand- und Kosten reduziert.

In dem Verdampferraum kann das Kühlfluid von einem flüssigen in einen gasförmigen Zustand übergehen und eine rotierende Supraleitungseinrichtung, insbesondere eine supraleitende Wicklung eines Rotors eines Motors oder eines Generators kühlen, wobei die supraleitende Wicklung insbesondere HTS-Material umfasst. Der Verdampferraum kann innerhalb des Rotors, insbesondere als zylindrischer Hohlraum entlang der Rotationsachse des Rotors rotierbar angeordnet werden.

Die wenigstens zwei Kaltköpfe und die wenigstens zwei Kondensorräume und insbesondere die wenigstens zwei Verbindungsrohre, welche insbesondere von einem die Verbindungsrohre umhüllenden Gesamtrohr umfasst werden, können feststehend angeordnet werden. Das Umhüllen der Verbindungsrohre durch ein Gesamtrohr ermöglicht die Verringerung der Zahl an Dichtungen und Lager beim Übergang der feststehenden auf die rotierenden Teile.

Bevorzugte Ausführungsformen der Erfindung mit vorteilhaften Weiterbildungen gemäß den Merkmalen der abhängigen Ansprüche werden nachfolgend anhand der Figuren näher erläutert, ohne jedoch darauf beschränkt zu sein.

Es wird in den Figuren dargestellt:
- Fig. 1: eine schematische Schnittdarstellung einer supraleitenden Maschine 2 mit einer Vorrichtung zur Kühlung nach dem Stand der Technik, und
- Fig. 2: eine vereinfachte schematische Darstellung einer Vorrichtung zur Kühlung, die für die Durchführung eines erfindungsgemäßen Verfahrens geeignet ist.

In den Figuren sind sich entsprechende Teile mit gleichen Bezugszeichen versehen.

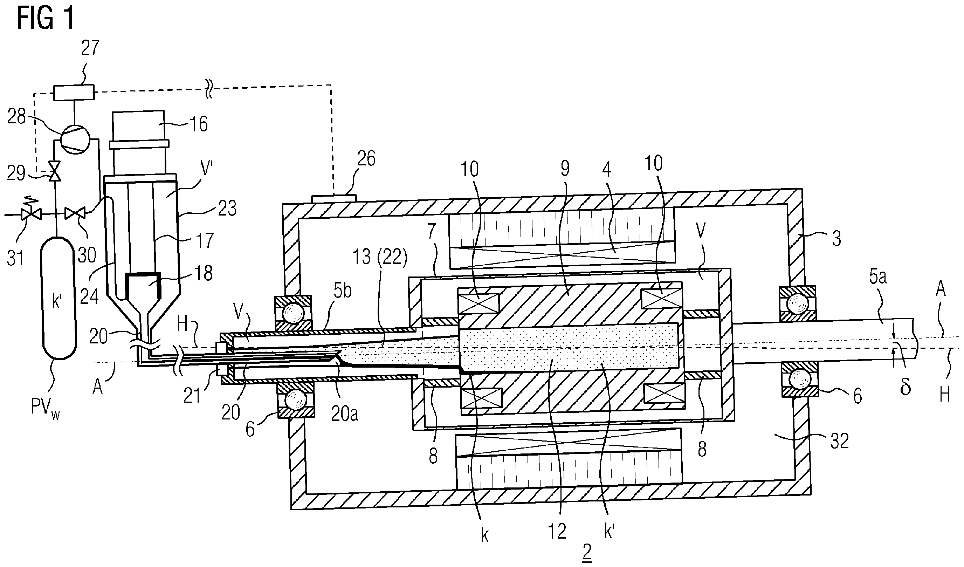

Maschinen entsprechend den Figuren umfassen jeweils einen Stator und Rotor sowie eine zugeordnete Kälteeinheit. Bei der nachfolgend angedeuteten Ausführungsform der Maschine kann es sich insbesondere um einen Synchron-Motor oder einen Generator handeln. Die Maschine umfasst eine rotierende, supraleitende Wicklung, die prinzipiell metallisches LTS-Material (Niedrig-T_{c}-Supraleitermaterial) oder oxidisches HTS-Material (Hoch-T_{c}-Supraleitermaterial) verwendet. Letzteres Material sei für die nachfolgenden Ausführungsbeispiele zu Grunde gelegt. Die Wicklung kann aus einer Spule oder aus einem System von Spulen in einer zwei-, vier- oder sonstigen mehrpoligen Anordnung bestehen. Der prinzipielle Aufbau eines entsprechenden Synchron-Motors geht aus Figur 1 hervor, wie er aus dem Stand der Technik bekannt ist.

Die mit 2 bezeichnete Maschine umfasst ein feststehendes, auf Raumtemperatur befindliches Außengehäuse 3 mit einer Ständerwicklung 4. Innerhalb des Außengehäuses und von der Ständerwicklung 4 umschlossen ist ein Rotor 5 drehbar um eine Rotationsachse A in Lagern 6 gelagert. Bei diesen Lagern kann es sich um konventionelle mechanische Lager oder auch um Magnetlager handeln. Der Rotor weist ferner ein Vakuumgefäß 7 auf, in dem an z.B. hohlzylindrischen, drehmomentübertragenden Aufhängeelementen 8 ein Wicklungsträger 9 mit einer HTS-Wicklung 10 gehaltert ist. In diesem Wicklungsträger ist konzentrisch zur Rotationsachse A ein sich in Achsrichtung erstreckender zentraler Hohlraum 12 vorhanden, der beispielsweise eine Zylinderform hat. Der Wicklungsträger ist dabei vakuumdicht gegenüber diesem Hohlraum ausgeführt. Er schließt diesen auf einer Seite des Rotors ab, der auf dieser Seite mittels eines massiven axialen Rotorwellenteils 5a gelagert ist. Auf der gegenüberliegenden Seite ist der zentrale Hohlraum 12 an einen seitlichen Hohlraum 13 mit vergleichsweise kleinerem Durchmesser angeschlossen. Dieser seitliche Hohlraum führt von dem Bereich des Wicklungsträgers nach außen aus dem Bereich des Außengehäuses 3 hinaus. Ein diesen seitlichen Hohlraum 13 umschließender, in einem der Lager gelagerter, rohrförmiger Rotorwellenteil ist mit 5b bezeichnet.

Zu einer indirekten Kühlung der HTS-Wicklung 10 über wärmeleitende Teile ist eine Kälteeinheit vorgesehen, von der lediglich ein Kaltkopf 16 angedeutet ist. Bei dieser Kälteeinheit kann es sich um einen Kryokühler vom Typ Gifford-McMahon oder insbesondere um einen regenerativen Kryokühler wie z.B. einen Pulsröhrenkühler oder einer Split-Stirling-Kühler handeln. Dabei befinden sich der Kaltkopf 16 und damit alle wesentlichen, weiteren Teile der Kälteeinheit außerhalb des Rotors 5 bzw. dessen Außengehäuses 3.

Das Kaltteil des beispielsweise etliche Meter seitlich von dem Rotor 5 angeordneten Kaltkopfes 16 steht in einem Vakuumgefäß 23 über einen Wärmeübertragungskörper 17 in gutem thermischen Kontakt mit einer Kältemittelkondensationseinheit, die einen Kondensorraum 18 aufweist. An diesem Kondensorraum ist ein vakuumisoliertes, ortsfestes Wärmerohr 20 angeschlossen, das seitlich in einem axialen Bereich in den seitlichen, mitrotierenden Hohlraum 13 oder den zentralen Hohlraum 12 hineinragt. Zur Abdichtung des Wärmerohres 20 gegenüber dem seitlichen Hohlraum 13 dient eine in der Figur nicht näher ausgeführte Dichtungseinrichtung 21 mit mindestens einem Dichtungselement, das als eine Ferrofluiddichtung und/oder eine Labyrinthdichtung und/oder eine Spaltdichtung ausgebildet sein kann. Über das Wärmerohr 20 und den seitlichen Hohlraum 13 ist der zentrale Hohlraum 12 mit dem Wärmetauschbereich des Kondensorraums 18 nach außen gasdicht abgedichtet verbunden. Die zwischen dem zentralen Hohlraum 12 und dem Kondensorraum 18 verlaufenden, rohrförmigen Teile, die zur Aufnahme eines Kältemittels dienen, sind allgemein als Leitungsteile 22 bezeichnet. Diese Leitungsteile werden zusammen mit dem Kondensorraum 18 und dem zentralen Hohlraum 12 als ein Leitungssystem betrachtet.

Diese Räume dieses Leitungssystems sind mit einem Kältemittel gefüllt, das je nach gewünschter Betriebstemperatur der HTS-Wicklung 10 ausgewählt wird. So kommen beispielsweise Helium (Kondensationstemperatur 4,2 K bei Normaldruck), Wasserstoff (Kondensationstemperatur 20,4 K bei Normaldruck), Neon (Kondensationstemperatur 27,1 K bei Normaldruck), Stickstoff (Kondensationstemperatur 77,4 K bei Normaldruck) oder Argon (Kondensationstemperatur 87,3 K bei Normaldruck) in Frage. Auch können Gemische aus diesen Gasen vorgesehen werden. Die Zirkulation des Kältemittels erfolgt dabei unter Ausnutzungen eines sogenannten Thermosiphon-Effektes. Hierzu wird an einer Kaltfläche des Kaltkopfes 16 im Bereich des Kondensorraums 18 das Kältemittel kondensiert. Anschließend fließt das so verflüssigte, mit k bezeichnete Kältemittel durch die Leitungsteile 22 in den zentralen Hohlraum 12. Der Transport des Kondensats geschieht dabei unter Einfluss der Schwerkraft. Hierzu kann vorteilhaft das Wärmerohr 20 geringfügig (um einige wenige Grad) gegenüber der Rotationsachse A in Richtung Erdmittelpunkt geneigt sein, um so ein Herausfließen des flüssigen Kältemittels k aus dem offenen Ende 20a des Rohres 20 zu unterstützen. Im Inneren des Rotors wird dann das flüssige Kältemittel verdampft. Das dampfförmige Kältemittel ist mit k' bezeichnet. Dieses unter Aufnahme von Wärme verdampfte Kältemittel strömt dann durch das Innere der Leitungsteile 22 zurück in den Kondensorraum 18. Hierbei wird der Rückstrom durch einen leichten Überdruck im als Verdampfer wirkenden Hohlraum 12 in Richtung auf den Kondensorraum 18 hin angefacht, der durch das Entstehen von Gas im Verdampfer und das Verflüssigen in dem Kondensorraum verursacht wird. Da die Zirkulation des verflüssigten Kältemittels von dem Kondensorraum 18 in den zentralen Hohlraum 12 und die Rückströmung des verdampften Kältemittels k' aus diesem Hohlraum zurück zu dem Kondensorraum in dem aus dem Kondensorraum 18, den Leitungsteilen 22 und dem Hohlraum 12 gebildeten rohrförmigen Leitungssystem erfolgt, kann von einem Ein-Rohr-System mit einer Zirkulation des Kältemittels k, k' unter Ausnutzung eines Thermosiphon-Effektes gesprochen werden.

Wie in Figur 1 ferner dargestellt ist, kann bei einem Einsatz der Maschine 2 auf Schiffen oder Off-shore-Einrichtungen eine Schieflage auftreten, bei der die Rotationsachse A gegenüber der Horizontalen H um einen Winkel δ von einigen Grad geneigt ist. Dann erfolgt zwar nach wie vor eine Kondensation des Kältemittels in dem Kondensorraum 18; aber das Kältemittel kann nicht mehr den zentralen Hohlraum 12 erreichen, so dass dann die Leitungsteile 20 allmählich mit flüssigem Kältemittel k volllaufen. Bei einer verhältnismäßig geringen Füllmenge des Leitungssystems mit Kältemittel kann dann der Läuferinnenraum bzw. der Hohlraum 12 trocken laufen und wird somit nicht mehr gekühlt. Auch bei einer größeren Füllmenge des Leitungssystems wird der Strom des flüssigen Kältemittels k in den Leitungsteilen 20 hin zum Verdampferraum 12 nach einer gewissen Zeit blockiert. Eine sichere Kühlung des Rotors bzw. seiner supraleitenden Wicklung ist in diesem Fall ebenfalls nicht mehr gewährleistet.

Gemäß dem Stand der Technik kann deshalb vorgesehen sein, dass in diesem Zustand der Gasdruck auf der Kondensorseite für eine kurze Zeit soweit zu erhöhen ist, dass hierdurch die Kältemittelflüssigkeit aus den Leitungsteilen 20 entgegen der Schwerkraft (bei Vorhandensein des Neigungswinkels δ) in den zentralen Hohlraum 12 gedrückt wird. Eine solche Druckerhöhung erfolgt gemäß dem Stand der Technik mit Hilfe eines warmen Puffervolumens PV_{w} und einer mechanischen Pumpe 28. Mit Hilfe dieser Mittel kann der Gasdruck in dem Kondensorraum 18 vorübergehend erhöht werden, so dass das dort und in den Leitungsteilen 20 befindliche flüssige Kältemittel k in den zentralen Hohlraum 12 gedrückt wird. In einer Verbindungsleitung 24 zwischen dem unter Überdruck stehenden Puffervolumen PV_{w} und dem Kondensorraum 18 ist deshalb ein Steuerventil 29 angeordnet, das die Verbindung zu der Pumpe 28 öffnet, die dann das Gas k' aus dem Puffervolumen in den Kondensorraum fördert. Ein Ventil 30 erlaubt eine Rückführung von überschüssigem Gas aus dem Kondensorraum 18.

Eine so hervorzurufende Druckoszillation kann permanent erfolgen, d.h. in kurzen, sich wiederholenden Zeitintervallen (jeweils für eine kurze Zeitdauer), oder kann durch einen Lagesensor 26 bekannter Bauweise von einer Steuereinheit 27 gesteuert werden. Dieser Lagesensor detektiert die Schieflage mit dem Neigungswinkel δ der Maschine 2 und löst so über die Steuereinheit 27 die erläuterte Einleitung eines Druckvolumens (Gaspulses) aus.

In Figur 1 wurde von einer Darstellung weiterer Teile zur Bereitstellung und Ableitung des Gases wie z.B. von einem Füllventil, von dem aus das System über die Verbindungsleitung 24 mit gasförmigem Kältemittel zu befüllen ist, abgesehen, da diese Teile allgemein bekannt sind. Lediglich ein bei einem unzulässigen Überdruck in dem System ansprechendes Überdruckventil 31 ist angedeutet.

Selbstverständlich müssen die das Kältemittel k bzw. k' umschließenden Teile oder Behältnisse gegen Wärmeeinleitung geschützt sein. Zu ihrer thermischen Isolation wird deshalb zweckmäßig eine Vakuumumgebung vorgesehen, wobei gegebenenfalls in den entsprechenden Vakuumräumen zusätzlich noch Isolationsmittel wie z.B. Superisolation oder Isolationsschaum vorgesehen werden können. In Figur 1 ist das von dem Vakuumgefäß 7 eingeschlossene Vakuum mit V bezeichnet. Es umgibt außerdem das den seitlichen Hohlraum 13 umschließende, sich bis zu der Dichtung 21 erstreckende Rohr. Dass das Wärmerohr 20 sowie den Kondensorraum 18 und den Wärmeübertragungskörper 17 umschließende Vakuum ist mit V' bezeichnet. Gegebenenfalls kann auch in dem den Rotor 5 umgebenden, von dem Außengehäuse 3 umschlossenen Innenraum 32 ein Unterdruck erzeugt werden.

Nachteilig an einem System der mechanischen Pumpe 28 und Ventile 29, 30, 31 ist, dass bei einer der Einfachheit halber nicht dargestellten Anordnung der Teile in einem kryogenen Bereich, bei kryogenen Temperaturen diese Teile sehr störanfällig sind und die Auslegung bewegter Teile auf diese Temperaturen aufwendig und kostenintensiv ist. Gerade in Hinblick auf den Einsatz auf Schiffen, aber auch bei anderen maschinentypischen Einsätzen, ist ein Wartungsfreier Betrieb über lange Zeiten notwendig. Mechanisch bewegte Teile sind deshalb auf ein Minimum zu reduzieren, da diese in der Regel störanfällig sind.

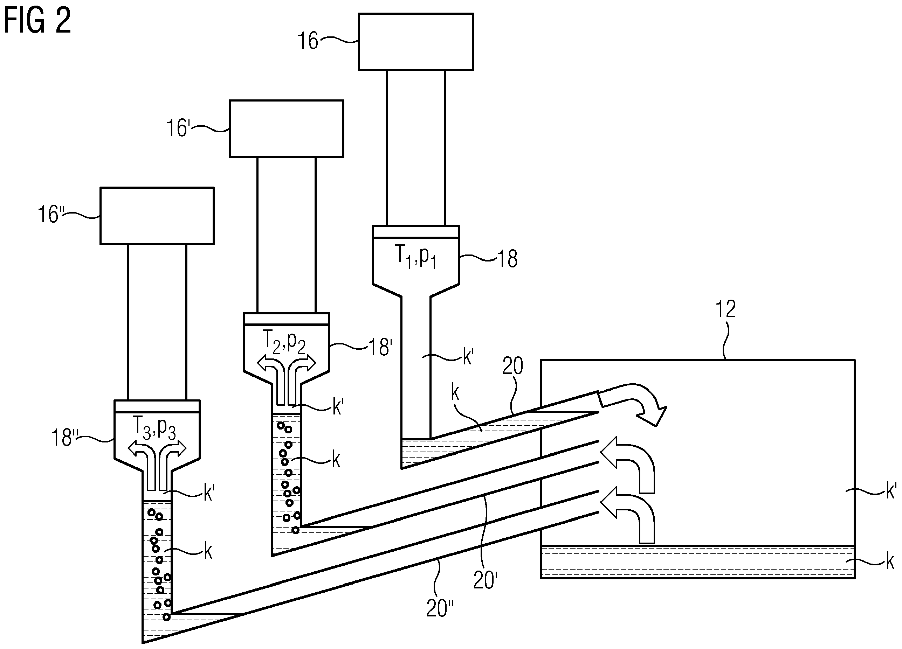

Erfindungsgemäß wird, wie in Fig. 2 dargestellt, in einer zuvor beschriebenen Maschine 2 ein neuartiges Kühlprinzip eingesetzt. Dabei kann auf Teile wie Pumpe 28 und Ventile 29, 30, 31 verzichtet werden, wobei alle weiteren Teile der Maschine analog denen der zuvor in Fig. 1 beschriebenen Maschine sind, soweit im Weiteren nicht anders erwähnt.

Im Gegensatz zu der in Fig. 1 dargestellten Vorrichtung mit einem Kaltkopf 16 und einem Kondensorraum 18 weist das in Fig. 2 dargestellte Ausführungsbeispiel der erfindungsgemäßen Vorrichtung zur Kühlung einer supraleitenden Maschine 2 einen ersten, zweiten und dritten Kondensorraum 18, 18', 18" jeweils mit einem zugeordneten Kaltkopf 16, 16', 16" auf. Alternativ können auch zwei oder mehr als drei Kondensorräume 18 mit zugeordneten Kaltköpfen 16 vorhanden sein, was der Einfachheit halber in den Fig. nicht dargestellt ist. Jeder Kondensorraum 18, 18', 18" ist über ein Wärmerohr 20, 20', 20", was im Weiteren allgemein als Verbindungsleitung 20, 20', 20" bezeichnet wird, fluidisch mit dem Verdampferraum 12, welcher in Fig. 1 durch den zentralen Hohlraum 12 gegeben ist, verbunden. Die Verbindungsleitungen 20, 20', 20" sind geneigt verzerrt V- oder U-förmig ausgebildet und angeordnet, d.h. sie sind leicht schräg im Bezug auf den Horizont H wie in Fig. 1 dargestellt, mit einem tiefsten Punkt, an welchem unter Einfluss der Schwerkraft sich ein Fluid ansammeln kann. Die Verbindungsleitungen 20, 20', 20" können aber auch andere Formen auf weisen, wobei wichtig ist, dass analog einem U-Rohr-Manometer sich Flüssigkeit in ihrem Inneren ansammeln kann.

Die Kondensorräume 18, 18', 18" mit den zugehörigen Verbindungsleitungen 20, 20', 20" und dem Verdampferraum 12 bilden ein geschlossenes System, d.h. einen nach außen hin fluiddichten Innenraum. Der Innenraum ist mit einem Kältemittel k, k', welches im Weiteren als Kühlfluid bezeichnet wird, befüllt. Das Kühlfluid kann im flüssigen k und/oder gasförmigen k' Aggregatzustand, d.h. als flüssiges Kühlfluid k und/oder als gasförmiges Kühlfluid k' vorliegen.

Im Betrieb der Maschine, bei welchem die supraleitende Wicklung 10 des Rotors 5 wie schon zuvor in Fig. 1 beschrieben, auf bzw. unter eine kryogene Temperatur Tₖ gekühlt wird, ist der Verdampferraum 12 teilweise mit flüssigem Kühlfluid k befüllt. Das Kühlfluid k verdampft und führt dadurch Wärmemenge aus dem Rotor 5 ab bzw. kühlt die supraleitende Wicklung 10 des Rotors 5. In Fig. 2 ist die erfindungsgemäße Vorrichtung zur Kühlung einer supraleitenden Maschine 2 zu einem ersten Zeitpunkt gezeigt. Zu diesem Zeitpunkt wird das gasförmige, verdampfte Kühlfluid k' aus dem Verdampferraum 12 über die Verbindungsleitungen 20' und 20" in die Kondensorräume 18' und 18" geleitet. In den Kondensorräumen 18' und 18" liegt eine Temperatur T₂ und T₃ unterhalb der Kondensationstemperatur des Kühlfluids k vor, jeweils mit Hilfe der zugeordneten Kühlköpfe 16' und 16", wodurch dem gasförmigen Kühlfluid k' Wärmemenge entzogen wird und es zu flüssigem Kühlfluid k kondensiert. Das flüssige Kühlfluid k sammelt sich in den Verbindungsleitungen 20' und 20".

Im ersten Kondensorraum 18 wird, ausgehend von einer Temperatur unterhalb der Kondensationstemperatur des Kühlfluids k die Temperatur T₁ mit Hilfe des zugeordneten Kaltkopfes 16 und/oder einer der Einfachheit halber nicht dargestellten Heizeinrichtung erhöht, auf eine Temperatur T₁* oberhalb der Kondensationstemperatur des Kühlfluids k. Dabei verdampft flüssiges Kühlfluid und/oder dehnt sich das gasförmige Kühlfluid k' im ersten Kondensorraum 18 aus, d.h. der Druck p₁ im ersten Kondensorraum 18 wird auf einen Wert erhöht, welcher höher als die Drücke pᵥ im Verdampferraum 12 und in den zwei weiteren Kondensorräumen 18', 18" p₂ und p₃ ist. Dadurch wird flüssiges Kühlfluid k, welches sich in der Verbindungsleitung 20 befindet, in den Verdampferraum 12 gedrückt, gegen die Wirkung der Schwerkraft bei einer Druckkraft, die größer als die Gewichtskraft des Kühlfluids k ist. Kühlfluid k aus dem Kondensorraum 18 und der Verbindungsleitung 20 wird in den Verdampferraum 12 gedrückt.

Dieser Effekt wird zusätzlich verstärkt durch einen Unterdruck p₁ und p₂ in den Kondensorräumen 18' und 18", welcher durch die Verringerung des Volumens des gasförmigen Kühlfluids k' bei Abkühlung und Kondensation in den Kondensorräumen 18'und 18" entsteht. Dieser Unterdruck saugt gasförmiges Kühlfluid k' aus dem Verdampferraum 12 in die Verbindungsleitungen 20'und 20" an und verringert so den Druck pᵥ im Verdampferraum 12. Der Druckunterschied Δp(p₁-pᵥ) zwischen dem ersten Kondensorraum 18 und dem Verdampferraum 12 wird dadurch verstärkt und zusätzlich zum Druckausgleich flüssiges Kühlfluid k aus der Verbindungsleitung 20 in den Verdampferraum 12 bewegt.

Der zuvor beschriebene Prozess endet unter anderem, wenn das flüssige Kühlfluid k aus der Verbindungsleitung 20 vollständig oder zumindest nahezu vollständig in den Verdampferraum 12 bewegt wurde. Um eine kontinuierliche Kühlung bzw. einen kontinuierlichen, quasikontinuierlichen oder einen gepulsten Kühlfluidstrom von flüssigem Kühlfluid k in den Verdampferraum 12 zu gewährleisten, kann rechtzeitig ein Tausch der Temperaturen T₁, T₂, T₃ in den Kondensorräumen 18, 18', 18" über die Kühlköpfe 16, 16', 16" erfolgen. Dabei kann der Kondensorraum 18 auf eine Temperatur unterhalb der Kondensationstemperatur des Kühlfluids über den Kühlkopf 16 gekühlt werden, wobei z.B. die Kondensorräume 18 und 18" die gleiche Temperatur aufweisen. Der Kondensorraum 18' kann über den Kühlkopf 16' oder eine der Einfachheit halber nicht dargestellten Heizeinrichtung auf eine Temperatur geheizt werden, welche oberhalb der Kondensationstemperatur des Kühlfluids liegt. Dies bewirkt, dass zu einem zweiten, in diesem Absatz beschriebenen Zeitpunkt, der Kondensorraum 18' wie der Kondensorraum 18 zum ersten Zeitpunkt wirkt, und zum zweiten Zeitpunkt die Kondensorräume 18 und 18" wie die Kondensorräume 18' und 18" zum ersten Zeitpunkt wirken. Im Kondensorraum 18' wird durch die Erhöhung der Temperatur ein Überdruck aufgebaut und flüssiges Kühlfluid k aus der Verbindungsleitung 20' in den Verdampferraum 12 bewegt. Da die Situation analog der in Fig. 2 dargestellten Situation ist, nur mit vertauschten Rollen (Temperaturen, Drücken und Fluidströmen) zwischen den Kondensorräumen 18, 18' und 18", ist die Situation bzw. der Prozess zum zweiten Zeitpunkt der Einfachheit halber in den Fig. nicht dargestellt.

Zu einem dritten Zeitpunkt kann die Wirkung der Kondensorräume 18, 18', 18" ebenfalls vertauscht werden, wobei der Kondensorraum 18" auf eine Temperatur oberhalb der Verdampfungstemperatur des Kühlfluids k mit Hilfe des Kühlkopfes 16" gebracht werden kann. Die Kondensorräume 18 und 18' können dabei z.B. die gleiche Temperatur aufweisen, eine Temperatur unterhalb der Kondensationstemperatur des Kühlfluids k'. Der Kondensorraum 18" kann über den Kühlkopf 16" oder eine der Einfachheit halber nicht dargestellten Heizeinrichtung auf eine Temperatur geheizt werden, welche oberhalb der Kondensationstemperatur des Kühlfluids liegt. Dies bewirkt, dass zum dritten Zeitpunkt der Kondensorraum 18" wie der Kondensorraum 18 zum ersten Zeitpunkt wirkt, und zum dritten Zeitpunkt die Kondensorräume 18 und 18' wie die Kondensorräume 18' und 18" zum ersten Zeitpunkt wirken. Im Kondensorraum 18" wird durch die Erhöhung der Temperatur ein Überdruck aufgebaut und flüssiges Kühlfluid k aus der Verbindungsleitung 20" in den Verdampferraum 12 bewegt. Da die Situation analog der in Fig. 2 dargestellten Situation ist, nur mit vertauschten Rollen (Temperaturen, Drücken und Fluidströmen) zwischen den Kondensorräumen 18, 18' und 18", ist die Situation bzw. der Prozess zum dritten Zeitpunkt der Einfachheit halber in den Fig. ebenfalls nicht dargestellt.

Zu einem vierten Zeitpunkt kann der Zustand des ersten Zeitpunktes wieder hergestellt werden. Durch ein regelmäßiges Tauschen der Wirkungen der Kondensorräume 18, 18', 18" nach einer festen Zeitperiode oder nach unterschiedlichen Zeiten, kann so ein kontinuierlicher, quasikontinuierlicher oder ein gepulster Betrieb der Vorrichtung zur Kühlung einer supraleitenden Maschine 2 sichergestellt werden.

Es sind auch beliebig andere Reihenfolgen bei der Vertauschung der Wirkung der Kondensorräume 18, 18', 18" möglich, wobei sich das Grundprinzip nicht ändert. Ein sicherer Kühlbetrieb kann so gewährleistet werden, selbst bei einer Neigung der Maschine 2 z.B. bei einem Einsatz in einem Schiff.

## Patentansprüche

1. Verfahren zur Kühlung einer supraleitenden Maschine (2) insbesondere unter Verwendung des Thermosiphoneffekts, umfassend die Schritte,
A) dass in einem ersten Kondensorraum (18, 18', oder 18"), welcher mit einem ersten Kaltkopf (16, 16", oder 16") thermisch in Verbindung steht, eine Temperatur (T₁, T₂, oder T₃) erhöht wird, wobei Kühlfluid verdampft wird und/oder sich Gas in dem Kondensorraum (18, 18', oder 18") ausdehnt und/oder der Druck (p₁, p₂, oder p₃) im Kondensorraum (18, 18', oder 18") erhöht wird, und flüssiges Kühlfluid k in einem ersten Verbindungsrohr (20, 20', oder 20") zwischen dem ersten Kondensorraum (18, 18', oder 18") und einem Verdampferraum (12) durch die Temperaturerhöhung, Verdampfung und/oder Gasausdehnung in den Verdampferraum (12) bewegt wird,
und
B) dass gleichzeitig in wenigstens einem zweiten Kondensorraum (18, 18', oder 18"), welcher mit einem zweiten Kaltkopf (16, 16', oder 16") thermisch in Verbindung steht, eine Temperatur (T₁, T₂, oder T₃) erniedrigt wird, insbesondere eine niedrigere Temperatur (T₁, T₂, oder T₃) als im ersten Kondensorraum (18, 18', oder 18"), wodurch gasförmiges Kühlfluid k' insbesondere über ein zweites Verbindungsrohr (20, 20', oder 20") von dem Verdampferraum (12) in den zweiten Kondensorraum (18, 18', oder 18") durch die Temperaturerhöhung im ersten Kondensorraum (18, 18', oder 18") und/oder durch die Temperaturerniedrigung im zweiten Kondensorraum (18, 18', oder 18") bewegt wird.

2. Verfahren zur Kühlung einer supraleitenden Maschine (2) insbesondere unter Verwendung des Thermosiphoneffekts, umfassend die Schritte,
C) dass in einem ersten Kondensorraum (18, 18', oder 18"), welcher mit einem ersten Kaltkopf (16, 16', oder 16") thermisch in Verbindung steht und welcher über ein erstes Verbindungsrohr (20, 20', oder 20") mit einem Verdampferraum (12) fluidisch in Verbindung steht, eine Temperatur (T₁, T₂, oder T₃) konstant gehalten wird,
und
D) dass gleichzeitig in wenigstens einem zweiten Kondensorraum (18, 18', oder 18"), welcher mit einem zweiten Kaltkopf (16, 16', oder 16") thermisch in Verbindung steht, eine Temperatur (T₁, T₂, oder T₃) erniedrigt wird, wodurch gasförmiges Kühlfluid k' über ein zweites Verbindungsrohr (20, 20', oder 20") zwischen dem Verdampferraum (12) und dem zweiten Kondensorraum (18, 18', oder 18") durch die Temperaturerniedrigung, eine Kondensation von Kühlfluid und/oder eine Kompression von Gas im zweiten Kondensorraum (18, 18', oder 18") aus dem Verdampferraum (12) in den zweiten Kondensorraum (18, 18', oder 18") bewegt wird,
und
E) wodurch flüssiges Kühlfluid k in dem ersten Verbindungsrohr (20, 20', oder 20") zwischen dem ersten Kondensorraum (18, 18', oder 18") und dem Verdampferraum (12) in den Verdampferraum (12) bewegt wird, durch die Temperaturerniedrigung, eine Kondensation von Kühlfluid und/oder eine Kompression von Gas im wenigstens zweiten Kondensorraum (18, 18', oder 18").

3. Verfahren nach Anspruch 1 oder 2, **dadurch gekennzeichnet, dass** gleichzeitig wenigstens in einem dritten Kondensorraum (18, 18', oder 18"), welcher mit einem dritten Kaltkopf (16, 16', oder 16") thermisch in Verbindung steht, eine Temperatur (T₁, T₂, oder T₃) konstant gehalten wird oder erniedrigt wird.

4. Verfahren nach Anspruch 3, **dadurch gekennzeichnet, dass** zeitlich direkt oder indirekt folgend auf die Schritte A) und B) oder C) bis E) in dem wenigstens einem Kondensorraum (18, 18', oder 18"), in welchem die Temperatur (T₁, T₂, oder T₃) zur Zeit der Schritte A) und B) oder C) bis E) erhöht wurde oder konstant gehalten wurde, die Temperatur (T₁, T₂, oder T₃) verringert oder konstant gehalten wird, und dass in dem wenigstens einen zweiten, insbesondere dem zweiten und dritten Kondensorraum (18, 18', oder 18"), in welchen die Temperatur (T₁, T₂, oder T₃) zur Zeit der Schritte A) und B) oder C) bis E) konstant gehalten wurde oder verringert wurde, die Temperatur (T₁, T₂, oder T₃) erhöht wird oder konstant gehalten wird.

5. Verfahren zur Kühlung einer supraleitenden Maschine (2) insbesondere unter Verwendung des Thermosiphoneffekts, umfassend die Schritte, dass in einem ersten Kondensorraum (18, 18', oder 18"), welcher mit einem ersten Kaltkopf (16, 16', oder 16") thermisch in Verbindung steht, und dass gleichzeitig in wenigstens einem zweiten Kondensorraum (18, 18', oder 18"), welcher mit einem zweiten Kaltkopf (16, 16', oder 16") thermisch in Verbindung steht, eine Temperatur (T₁, T₂, oder T₃) erhöht wird, wobei die Temperatur und/oder Temperaturerhöhung im ersten Kondensorraum (18, 18', oder 18") größer ist als im zweiten Kondensorraum (18, 18', oder 18"), wodurch im ersten Kondensorraum (18, 18', oder 18") mehr Kühlfluid verdampft wird als im zweiten Kondensorraum (18, 18', oder 18") und/oder sich Gas mehr ausdehnt und/oder ein Druckunterschied zwischen dem Druck (p₁, p₂, oder p₃) im ersten und zweiten Kondensorraum (18, 18', oder 18") entsteht oder erhöht wird, wodurch flüssiges Kühlfluid k in einem ersten Verbindungsrohr (20, 20', oder 20") zwischen dem ersten Kondensorraum (18, 18', oder 18") und einem Verdampferraum (12) bewegt wird, und gasförmiges Kühlfluid k' insbesondere über ein zweites Verbindungsrohr (20, 20', oder 20") von dem Verdampferraum (12) in den zweiten Kondensorraum (18, 18', oder 18") bewegt wird.

6. Verfahren zur Kühlung einer supraleitenden Maschine (2) insbesondere unter Verwendung des Thermosiphoneffekts, umfassend die Schritte, dass in einem ersten Kondensorraum (18, 18', oder 18"), welcher mit einem ersten Kaltkopf (16, 16', oder 16") thermisch in Verbindung steht, und dass gleichzeitig in wenigstens einem zweiten Kondensorraum (18, 18', oder 18"), welcher mit einem zweiten Kaltkopf (16, 16', oder 16") thermisch in Verbindung steht, eine Temperatur (T₁, T₂, oder T₃) verringert wird, wobei die Temperatur im ersten Kondensorraum (18, 18', oder 18") kleiner ist als im zweiten Kondensorraum (18, 18', oder 18") und/oder die Temperaturverringerung im ersten Kondensorraum (18, 18', oder 18") größer ist als im zweiten Kondensorraum (18, 18', oder 18"), wodurch im ersten Kondensorraum (18, 18', oder 18") mehr Kühlfluid kondensiert wird als im zweiten Kondensorraum (18, 18', oder 18") und/oder Gas mehr komprimiert wird und/oder ein Druckunterschied zwischen dem Druck (p₁, p₂, oder p₃) im ersten und zweiten Kondensorraum (18, 18', oder 18") entsteht oder erhöht wird, wodurch flüssiges Kühlfluid k in einem zweiten Verbindungsrohr (20, 20', oder 20") zwischen dem zweiten Kondensorraum (18, 18', oder 18") und einem Verdampferraum (12) bewegt wird, und gasförmiges Kühlfluid k' insbesondere über ein erstes Verbindungsrohr (20, 20', oder 20") von dem Verdampferraum (12) in den ersten Kondensorraum (18, 18', oder 18") bewegt wird.

7. Verfahren nach einem der Ansprüche 5 oder 6, **dadurch gekennzeichnet, dass** gleichzeitig wenigstens in einem dritten Kondensorraum (18, 18', oder 18"), welcher mit einem dritten Kaltkopf (16, 16', oder 16") thermisch in Verbindung steht, eine Temperatur (T₁, T₂, oder T₃) erhöht, gleichgehalten oder verringert wird.

8. Verfahren nach Anspruch 7, **dadurch gekennzeichnet, dass** zeitlich direkt oder indirekt folgend in Kondensorräumen (18, 18', oder 18"), in welchen die Temperatur (T₁, T₂, oder T₃) erhöht wurde, die Temperatur (T₁, T₂, oder T₃) verringert wird, und/oder dass zeitlich direkt oder indirekt folgend in Kondensorräumen (18, 18', oder 18"), in welchen die Temperatur (T₁, T₂, oder T₃) verringert wurde, die Temperatur (T₁, T₂, oder T₃) erhöht wird.

9. Verfahren nach einem der vorangehenden Ansprüche, **dadurch gekennzeichnet, dass** das Verfahren als ein kontinuierlicher oder gepulster Prozess des Pumpens von flüssigem Kühlfluid k in den Verdampferraum (12) durchgeführt wird.

10. Verfahren nach einem der vorangehenden Ansprüche, **dadurch gekennzeichnet, dass** eine Temperaturerniedrigung durch Kühlen mit Hilfe wenigstens eines Kaltkopfes (16, 16', 16") erfolgt und/oder eine Temperaturerhöhung mit Hilfe wenigstens eines Kaltkopfes (16, 16', 16") und/oder durch Heizen mit Hilfe einer Heizeinrichtung erfolgt.

11. Verfahren nach einem der vorangehenden Ansprüche, **dadurch gekennzeichnet, dass** eine Bewegung von Kühlfluid k, k' ausschließlich geregelt oder gesteuert über Druck- und/oder Temperaturunterschiede in den Kondensorräumen (18, 18', 18") und dem Verdampferraum (12) erfolgt, insbesondere bei Druckausgleich durch Kühlfluidbewegung und/oder insbesondere gegen die Schwerkraft.

12. Verfahren nach einem der vorangehenden Ansprüche, **dadurch gekennzeichnet, dass** in dem Verdampferraum (12) das Kühlfluid von einem flüssigen k in einen gasförmigen k' Zustand übergeht und eine rotierende Supraleitungseinrichtung, insbesondere eine supraleitende Wicklung (10) eines Rotors (5) eines Motors oder eines Generators kühlt, wobei die supraleitende Wicklung (10) insbesondere HTS-Material umfasst und/oder wobei der Verdampferraum (12) innerhalb des Rotors (5), insbesondere als zylindrischer Hohlraum (12, 13) entlang der Rotationsachse (A) des Rotors (5) rotierbar angeordnet wird.

13. Verfahren nach einem der vorangehenden Ansprüche, **dadurch gekennzeichnet, dass** die wenigstens zwei Kaltköpfe (16, 16', 16") und die wenigstens zwei Kondensorräume (18, 18', 18") und insbesondere die wenigstens zwei Verbindungsrohre (20, 20', 20"), welche insbesondere von einem die Verbindungsrohre (20, 20', 20") umhüllenden Gesamtrohr umfasst werden, feststehend angeordnet werden.

## Claims

1. Method for cooling a superconducting machine (2), in particular using the thermosiphon effect, comprising the steps:
A) that a temperature (T₁, T₂, or T₃) is increased in a first condenser chamber (18, 18', or 18"), which is thermally connected to a first cold head (16, 16', or 16"), wherein cooling fluid is evaporated and/or gas in the condenser chamber (18, 18', or 18") expands and/or the pressure (p₁, p₂ or p₃) in the condenser chamber (18, 18', or 18") is increased, and liquid cooling fluid k is moved in a first connecting pipe (20, 20', or 20") between the first condenser chamber (18, 18', or 18") and an evaporator chamber (12) into the evaporator chamber (12) by the temperature increase, evaporation and/or gas expansion,
and
B) that a temperature (T₁, T₂, or T₃) is lowered simultaneously in at least one second condenser chamber (18, 18', or 18"), which is thermally connected to a second cold head (16, 16', or 16"), in particular a lower temperature (T₁, T₂, or T₃) than in the first condenser chamber (18, 18', or 18"), as a result of which gaseous cooling fluid k' is moved from the evaporator chamber (12) into the second condenser chamber (18, 18', or 18"), in particular via a second connecting pipe (20, 20', or 20"), as a result of the temperature increase in the first condenser chamber (18, 18', or 18") and/or by the lowering of the temperature in the second condenser chamber (18, 18', or 18").

2. Method for cooling a superconducting machine (2), in particular using the thermosiphon effect, comprising the steps:
C) that a constant temperature (T₁, T₂, or T₃) is maintained in a first condenser chamber (18, 18', or 18"), which is thermally connected to a first cold head (16, 16', or 16") and which is fluidically connected to an evaporator chamber (12) via a first connecting pipe (20, 20', or 20")
and
D) that a temperature (T₁, T₂, or T₃) is lowered simultaneously in at least one second condenser chamber (18, 18', or 18"), which is thermally connected to a second cold head (16, 16', or 16"), whereby gaseous cooling fluid k' is moved from the evaporator chamber (12) into the second condenser chamber (18, 18', or 18") via a second connecting pipe (20, 20', or 20") between the evaporator chamber (12) and the second condenser chamber (18, 18', or 18"), as a result of the temperature reduction, a condensation of cooling fluid and/or a compression of gas in the second condenser chamber (18, 18', or 18"),
and
E) whereby liquid cooling fluid k is moved into the evaporator chamber (12) in the first connecting pipe (20, 20', or 20") between the first condenser chamber (18, 18', or 18") and the evaporator chamber (12) as a result of the temperature reduction, a condensation of cooling fluid and/or a compression of gas in the at least second condenser chamber (18, 18' , or 18").

3. Method according to claim 1 or 2, **characterised in that** a temperature (T₁, T₂, or T₃) is constantly maintained or lowered simultaneously at least in one third condenser chamber (18, 18', or 18"), which is thermally connected to the third cold head (16, 16', or 16").

4. Method according to claim 3, **characterised in that**, directly or indirectly subsequent to steps A) and B) or C) to E), in the at least one condenser chamber (18, 18', or 18"), in which the temperature (T₁, T₂, or T₃) at the time of steps A) and B) or C) to E) was increased or maintained at a constant level, the temperature (T₁, T₂, or T₃) is lowered or kept at a constant level, and that, in the at least one second, in particular the second and third condenser chamber (18, 18', or 18"), in which the temperature (T₁, T₂, or T₃) at the time of steps A) and B) or C) to E) was maintained at a constant level or was lowered, the temperature (T₁, T₂, or T₃) is increased or maintained at a constant level.

5. Method for cooling a superconducting machine (2), in particular using the thermosiphon effect, comprising the steps that, in a first condenser chamber (18, 18', or 18"), which is thermally connected to a first cold head (16, 16', or 16"), and that, in at least one second condenser chamber (18, 18', or 18"), which is thermally connected to a second cold head (16, 16', or 16"), a temperature (T₁, T₂, or T₃) is simultaneously increased, wherein the temperature and/or temperature increase in the first condenser chamber (18, 18', or 18") is greater than in the second condenser chamber (18, 18', or 18"), as a result of which in the first condenser chamber (18, 18', or 18") more cooling fluid is evaporated than in the second condenser chamber (18, 18', or 18") and/or gas is more expanded and/or a pressure difference is created or increased between the pressure (p₁, p₂, or p₃) in the first and second condenser chamber (18, 18', or 18"), as a result of which liquid cooling fluid k is moved in a first connecting pipe (20, 20', or 20") between the first condenser chamber (18, 18', or 18") and an evaporator chamber (12), and gaseous cooling fluid k' is moved from the evaporator chamber (12) into the second condenser chamber (18, 18', or 18") in particular via a second connecting pipe (20, 20', or 20").

6. Method for cooling a superconducting machine (2), in particular using the thermosiphon effect, comprising the steps, that, in a first condenser chamber (18, 18', or 18") which is thermally connected to a first cold head (16, 16', or 16"), and that, in at least one second condenser chamber (18, 18', or 18"), which is thermally connected to a second cold head (16, 16', or 16"), a temperature (T₁, T₂, or T₃) is simultaneously lowered, wherein the temperature in the first condenser chamber (18, 18', or 18") is lower than in the second condenser chamber (18, 18', or 18") and/or the temperature reduction in the first condenser chamber (18, 18', or 18") is greater than in the second condenser chamber (18, 18', or 18"), as a result of which more cooling fluid is condensed in the first condenser chamber (18, 18', or 18") than in the second condenser chamber (18, 18', or 18"), and/or gas is more compressed and/or a pressure difference is created or increased between the pressure (p₁, p₂, or p₃) in the first and second condenser chamber (18, 18', or 18"), as a result of which liquid cooling fluid k is moved in a second connecting pipe (20, 20', or 20") between the second condenser chamber (18, 18', or 18") and an evaporator chamber (12), and gaseous cooling fluid k' is moved from the evaporator chamber (12) into the first condenser chamber (18, 18', or 18"), in particular via a first connecting pipe (20, 20', or 20").

7. Method according to one of claims 5 or 6, **characterised in that** a temperature (T₁, T₂, or T₃) is increased, maintained or lowered simultaneously at least in one third condenser chamber (18, 18', or 18"), which is thermally connected to a third cold head (16, 16', or 16").

8. Method according to claim 7, **characterised in that**, directly or indirectly subsequent thereto, the temperature (T₁, T₂, or T₃) is reduced in condenser chambers (18, 18', or 18") in which the temperature (T₁, T₂, or T₃) was increased, and/or in that, directly or indirectly subsequent thereto, the temperature (T₁, T₂, or T₃) is increased in condenser chambers (18, 18', or 18") in which the temperature (T₁, T₂, or T₃) was reduced.

9. Method according to one of the preceding claims, **characterised in that** the method is carried out as a continuous or pulsed process of pumping liquid cooling fluid k into the evaporator chamber (12).

10. Method according to one of the preceding claims, **characterised in that** a temperature reduction is effected by cooling with the help of at least one cold head (16, 16', 16") and/or a temperature increase is effected with the help of at least one cold head (16, 16', 16") and/or by heating with the help of a heating device.

11. Method according to one one of the preceding claims, **characterised in that** a movement of cooling fluid k, k' is regulated or controlled only via differences in pressure and/or temperature in the condenser chambers (18, 18', 18") and the evaporator chamber (12), particularly in the case of pressure equalisation by cooling fluid movement and/or in particular against the force of gravity.

12. Method according to one of the preceding claims, **characterised in that**, in the evaporator chamber (12), the cooling fluid can pass from a liquid k into a gaseous k' state, and cools a rotating superconducting device, in particular a superconducting winding (10) of a rotor (5) of a motor or generator, wherein the superconducting winding (10) comprises in particular HTS material and/or wherein the evaporator chamber (12) may be rotatably arranged inside the rotor (5), in particular as a cylindrical cavity (12, 13) along the rotation axis (A) of the rotor (5).

13. Method according to one of the preceding claims, **characterised in that** the at least two cold heads (16, 16', 16") and the at least two condenser chambers (18, 18', 18") and, in particular, the at least two connecting pipes (20, 20', 20"), which - in particular - are contained by a composite pipe that encases the connecting pipes (20, 20', 20"), are arranged in a stationary position.

## Revendications

1. Procédé de refroidissement d'une machine (2) supraconductrice, notamment en utilisant l'effet de thermosiphon, comprenant les stades,
A) on élève une température (T₁, T₂, ou T₃) dans un premier espace (18, 18', ou 18") de condenseur, qui est en liaison thermiquement avec une première tête (16, 16', ou 16") froide, du fluide de refroidissement étant évaporé et/ou on détent du gaz dans l'espace (18, 18', ou 18") de condenseur et/ou on élève la pression (p₁, p₂, ou p₃) dans l'espace (18, 18', ou 18") de condenseur et on déplace du fluide k de refroidissement liquide dans un premier tuyau (20, 20', ou 20") de liaison entre le premier espace (18, 18', ou 18") de condenseur et un espace (12) d'évaporateur, par l'élévation de température, l'évaporation et/ou la détente du gaz dans l'espace (12) d'évaporateur,
et
B) on abaisse en même temps une température (T₁, T₂, ou T₃) dans au moins un deuxième espace (18, 18', ou 18") de condenseur, qui est en liaison thermiquement avec une deuxième tête (16, 16', ou 16") froide, en ayant notamment une température (T₁, T₂, ou T₃) plus basse que dans le premier espace (18, 18', ou 18") de condenseur, grâce à quoi on fait passer du fluide k' de refroidissement sous forme gazeuse, notamment par un deuxième tuyau (20, 20', ou 20") de liaison, de l'espace (12) d'évaporateur au deuxième espace (18, 18', ou 18") de condenseur, par l'élévation de température dans le premier espace (18, 18', ou 18") de condenseur et/ou par l'abaissement de température dans le deuxième espace (18, 18', ou 18") de condenseur.

2. Procédé de refroidissement d'une machine (2) supraconductrice, notamment en utilisant l'effet de thermosiphon, comprenant les stades,
C) on maintien constante une température (T₁, T₂, ou T₃) dans un premier espace (18, 18', ou 18") de condenseur, qui est en liaison thermiquement avec une première tête (16, 16', ou 16") froide et qui est en liaison fluidiquement avec un espace (12) d'évaporateur par un premier tuyau (20, 20', ou 20") de liaison et
D) en même temps on abaisse une température (T₁, T₂, ou T₃) dans au moins un deuxième espace (18, 18', ou 18") de condenseur, qui est en liaison thermiquement avec une deuxième tête (16, 16', ou 16") froide, grâce à quoi on fait passer, de l'espace (12) d'évaporateur au deuxième espace (18, 18', ou 18") de condenseur, du fluide k' de refroidissement sous forme gazeuse, par un deuxième tuyau (20, 20', ou 20") de liaison entre l'espace (12) d'évaporateur et le deuxième espace (18, 18', ou 18") de condenseur, par l'abaissement de température, par une condensation de fluide de refroidissement et/ou par une compression de gaz dans le deuxième espace (18, 18', ou 18") de condenseur et
E) grâce à quoi, on fait passer, dans l'espace (12) d'évaporateur, du fluide k de refroidissement liquide dans le premier tuyau (20, 20', ou 20") de liaison entre le premier espace (18, 18', ou 18") de condenseur et l'espace (12) d'évaporateur par l'abaissement de température, par une condensation de fluide de refroidissement et/ou par une compression de gaz dans au moins le deuxième espace (18, 18', ou 18") de condenseur.

3. Procédé suivant la revendication 1 ou 2, **caractérisé en ce que** l'on maintient constante, ou on abaisse, une température (T₁, T₂, ou T₃) en même temps au moins dans un troisième espace (18, 18', ou 18") de condenseur, qui est en liaison thermiquement avec une troisième tête (16, 16', ou 16") froide.

4. Procédé suivant la revendication 3, **caractérisé en ce que** l'on abaisse ou maintient constante la température (T₁, T₂, ou T₃) directement ou indirectement dans le temps, à la suite des stades A) et B) ou C) à E) dans le au moins un espace (18, 18', ou 18") de condenseur, dans lequel la température (T₁, T₂, ou T₃) a été élevée ou a été maintenue constante au temps des stades A) et B) ou C) à E) et **en ce que**, dans le au moins un deuxième, notamment dans le deuxième et troisième espace (18, 18', ou 18") de condenseur, dans lequel on a maintenu constante ou on a abaissé la température (T₁, T₂, ou T₃) au temps des stades A) et B) ou C) à E), on élève ou on maintient constante la température (T₁, T₂, ou T₃).

5. Procédé de refroidissement d'une machine (2) supraconductrice, notamment en utilisant l'effet de thermosiphon, comprenant les stades dans lesquels, dans un premier espace (18, 18', ou 18") de condenseur, qui est en liaison thermiquement avec une première tête (16, 16', ou 16") froide et, en même temps dans au moins un deuxième espace (18, 18', ou 18") de condenseur, qui est en liaison thermiquement avec une deuxième tête (16, 16', ou 16") froide, on élève une température (T₁, T₂, ou T₃), la température et/ou l'élévation de température, dans le premier espace (18, 18', ou 18") de condenseur, étant plus grande que dans le deuxième espace (18, 18', ou 18") de condenseur, grâce à quoi on évapore, dans le premier espace (18, 18', ou 18") de condenseur, plus de fluide de refroidissement que dans le deuxième espace (18, 18', ou 18") de condenseur et/ou on détend plus de gaz et/ou on crée ou on augmente une différence de pression entre la pression (p₁, p₂, ou p₃) dans le premier et le deuxième espace (18, 18', ou 18") de condenseur, grâce à quoi on fait passer du fluide k de refroidissement liquide dans un premier tuyau (20, 20', ou 20") de liaison entre le premier espace (18, 18', ou 18") de condenseur et un espace (12) d'évaporateur et on fait passer, de l'espace (12) d'évaporateur au deuxième espace (18, 18', ou 18") de condenseur, du fluide k' de refroidissement sous forme gazeuse, notamment par un deuxième tuyau (20, 20', ou 20") de liaison.

6. Procédé de refroidissement d'une machine (2) supraconductrice, notamment en utilisant l'effet de thermosiphon, comprenant les stades dans lesquels, dans un premier espace (18, 18', ou 18") de condenseur, qui est en liaison thermiquement avec une première tête (16, 16', ou 16") froide et en même temps dans au moins un deuxième espace (18, 18', ou 18") de condenseur, qui est en liaison thermiquement avec une deuxième tête (16, 16', ou 16") froide, on abaisse une température (T₁, T₂, ou T₃), la température dans le premier espace (18, 18', ou 18") de condenseur étant plus basse que dans le deuxième espace (18, 18', ou 18") de condenseur et/ou l'abaissement de température dans le premier espace (18, 18', ou 18") de condenseur étant plus grand que dans le deuxième espace (18, 18', ou 18") de condenseur, grâce à quoi on condense, dans le premier espace (18, 18', ou 18") de condenseur, plus de fluide de refroidissement que dans le deuxième espace (18, 18', ou 18") de condenseur et/ou on comprime plus de gaz et/ou on crée ou on augmente une différence de pression entre la pression (p₁, p₂, ou p₃) dans le premier et le deuxième espace (18, 18', ou 18") de condenseur, grâce à quoi on fait passer du fluide k de refroidissement liquide dans un deuxième tuyau (20, 20', ou 20") de liaison entre le premier espace (18, 18', ou 18") de condenseur et un espace (12) d'évaporateur et on fait passer, de l'espace (12) d'évaporateur au premier espace (18, 18', ou 18") de condenseur, du fluide k' de refroidissement sous forme gazeuse par un premier tuyau (20, 20', ou 20") de liaison.

7. Procédé suivant l'une des revendications 5 ou 6, **caractérisé en ce qu'**en même temps on élève, maintient égale ou abaisse une température (T₁, T₂, ou T₃), au moins dans un troisième espace (18, 18', ou 18") de condenseur, qui est en liaison thermiquement avec une troisième tête (16, 16', ou 16") froide.

8. Procédé suivant la revendication 7, **caractérisé en ce qu'**en même temps, directement ou indirectement à la suite, dans des espaces (18, 18', ou 18") de condenseur, dans lesquels la température (T₁, T₂, ou T₃) était élevée, on diminue la température (T₁, T₂, ou T₃) et/ou **en ce que** dans le temps, directement ou indirectement à la suite dans des espaces (18, 18', ou 18") de condenseur, dans lesquels la température (T₁, T₂, ou T₃) était diminuée, on élève la température (T₁, T₂, ou T₃).

9. Procédé suivant l'une des revendications précédentes, **caractérisé en ce que** l'on effectue le procédé sous la forme d'un processus continu ou pulsé du pompage de fluide k de refroidissement liquide dans l'espace (12) d'évaporateur.

10. Procédé suivant l'une des revendications précédentes, **caractérisé en ce qu'**un abaissement de la température s'effectue par refroidissement à l'aide d'au moins une tête (16, 16', ou 16") froide et/ou une élévation de température s'effectue à l'aide d'au moins une tête (16, 16', ou 16") froide et/ou par chauffage à l'aide d'un dispositif de chauffage.

11. Procédé suivant l'une des revendications précédentes, **caractérisé en ce que** l'on régule ou commande un déplacement du fluide k, k' de refroidissement, exclusivement par des différences de pression et/ou de température dans les espaces (18, 18', ou 18") de condenseur et dans l'espace (12) d'évaporateur, notamment par compensation de pression par déplacement de fluide de refroidissement et/ou notamment à l'encontre de la force de la gravité.

12. Procédé suivant l'une des revendications précédentes, **caractérisé en ce que**, dans l'espace (12) d'évaporateur, le fluide de refroidissement passe d'un état liquide k à un état k' gazeux et refroidit un dispositif tournant à supraconducteur, notamment un enroulement (10) supraconducteur d'un rotor (5) d'un moteur ou d'une génératrice, l'enroulement (10) supraconducteur comprenant notamment du matériau HTS et/ou dans lequel l'espace (12) d'évaporateur est monté tournant à l'intérieur du rotor (5), notamment sous la forme d'une cavité (12, 13) cylindrique le long de l'axe (A) de rotation du rotor (5).

13. Procédé suivant l'une des revendications précédentes, **caractérisé en ce que** l'on monte de manière fixe les au moins deux têtes (16, 16', ou 16") froides et les au moins deux espaces (18, 18', ou 18") de condenseur et notamment les au moins deux tuyaux (20, 20', ou 20") de liaison, qui sont entourés notamment par un tuyau d'ensemble entourant les tuyaux (20, 20', ou 20") de liaison.
